Europäisches Patentamt

European Patent Office

Office européen des brevets

(19)

(11) Publication number: **0 456 251 A2**

# EUROPEAN PATENT APPLICATION

(21) Application number: 91107610.7

(51) Int. Cl.5: **H03K 19/094**, H03K 19/013

(22) Date of filing: **10.05.91**

(30) Priority: **10.05.90 JP 118685/90**

(43) Date of publication of application:
**13.11.91 Bulletin 91/46**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Nagamatsu, Tetsu, c/o Int. Pty. Div.,**

**K.K. Toshiba**
**1-1 Shibaura 1-chome, Minato-ku**
**Toyko 105(JP)**
Inventor: **Tsugaru, Kazunori, c/o Int. Pty. Div.,**
**K.K. Toshib**
**1-1 Shibaura 1-chome, Minato-ku**
**Toyko 105(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **Logic gate.**

(57) In a logic gate according to this invention, a power source potential ($V_{DD}$) is applied to the source of a p-channel MOSFET (11). A power source potential ($V_{SS}$) is applied to the sources of n-channel MOSFETs (12, 13). The gates of the MOSFETs (11, 12, 13) are connected to an input terminal (IN). A power source potential ($V_{CC}$) is applied to the collector of a bipolar transistor (14). The base of the bipolar transistor is connected to the drains of the MOSFETs (11, 12). The drain of the MOSFET (13) and the emitter of the bipolar transistor (14) are connected to an output terminal (OUT). A resistive element (15) is connected between the base and emitter of the bipolar transistor (14). There is provided a logic gate which can operate at a high speed with low power consumption and uses a high-level output potential as a power source potential ($V_{DD}$).

F I G. 5

The present invention relates to an improvement in a Bi-CMOS logic gate constituted by composing a bipolar transistor and a CMOS (complementary MOS).

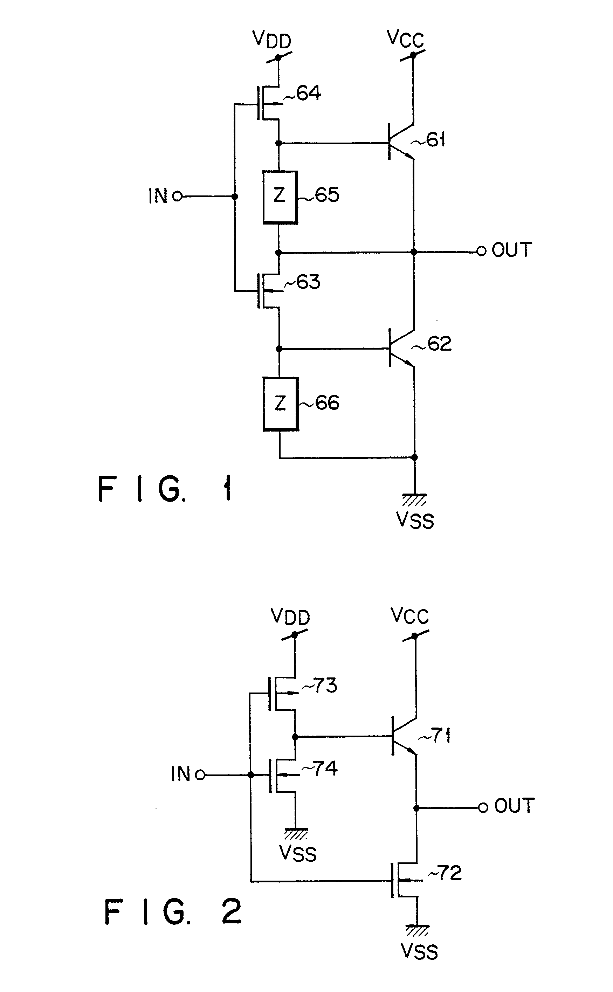

It is well-known that the operation speed of the Bi-CMOS logic gate is higher than that of the CMOS logic gate. When the design rule of transistors constituting the Bi-CMOS logic gate is about 0.8 $\mu$m, a power source potential is generally 5 V. Therefore, as shown in Fig. 1, the Bi-CMOS logic gate is a totempole logic gate having bipolar transistors 61 and 62 in its output section. Referring to Fig. 1, reference numeral 64 denotes a MOSFET, and reference numerals 65 and 66 denote impedance elements.

When the design rule of transistors constituting the Bi-CMOS logic gate is about 0.5 to 0.6 $\mu$m, a power source potential is generally about 3.3 V.

In this case, the source of a MOSFET 63 is connected to the base of the bipolar transistor 62 connected to a ground potential side (pull-down side). For this reason, when an output potential is set at low level, the source potential of the MOSFET 63 is higher than the ground potential by a base-emitter voltage of the bipolar transistor 62. Therefore, when the output potential is changed from high level to low level, drivability of the MOSFET 63 is decreased by influences such as a backgate bias effect, a decrease in gate-source voltage, and a decrease in drain-source voltage.

As described above, a gate delay time ($T_{PHL}$) for changing the output voltage from high level to low level is prolonged as the degree of micropatterning of the MOSFET is increased, thereby degrading delay characteristics.

In order to improve the delay characteristics, a logic gate shown in Fig. 2 is proposed. In Fig. 2, reference numeral 71 denotes a bipolar transistor, and reference numerals 72 to 74 denote MOSFETs. In the output section of the logic gate, the n-channel MOSFET 72 is used as a transistor connected to a ground potential. The gate of the MOSFET 72 is connected to an input terminal IN.

This logic gate is called a Bi-NMOS logic gate. The Bi-NMOS logic gate has a feature in which a gate delay time ($T_{PHL}$) for changing an output potential from high level to low level is shorter than that of a Bi-CMOS logic gate. That is, when the output potential is changed from high level to low level, charges are immediately extracted from the base of the bipolar transistor 71 by the MOSFET 74.

However, the high-level output potential of the Bi-NMOS logic gate is lower than a power source $V_{DD}$ by a base-emitter voltage of the bipolar transistor 71. That is, since the high-level output potential is lower than the power source potential, an erroneous operation may occur in other logic gates of next stage to which the output potential is applied, and a through current may be generated from these logic gates.

Therefore, there is provided a logic gate in which a resistive element, e.g., a resistor, a p-channel MOSFET having a fixed gate potential, or the like is used as elements for extracting charges of base of the bipolar transistor 71 connected to the power source potential $V_{CC}$.

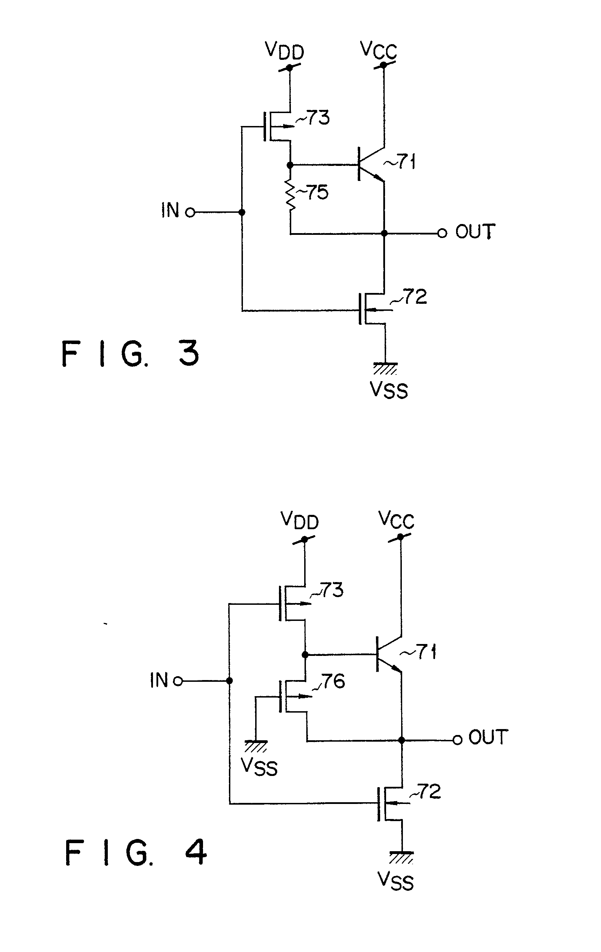

Fig. 3 shows a case wherein a resistor 75 is used as the element for extracting charges from the bipolar transistor 71, and Fig. 4 shows a case wherein a p-channel MOSFET 76 having a fixed gate potential is used as the element. Since the delay characteristics of the logic gates shown in Figs. 3 and 4 have small dependency in a power source potential and have a high level as a power source potential $V_{DD}$, erroneous operations and generation of a through current can be prevented in other logic gates of next stage of the logic gates.

In the above arrangement, when the output potential is changed from low level to high level, a current flowing through the MOSFET 73 is shunted into the base of the bipolar transistor 71 and a resistor 75 or the p-channel MOSFET 76 having the fixed gate potential. For this reason, in the logic gates shown in Figs. 3 and 4, a gate delay time ($T_{PLH}$) for changing the output potential from low level to high level is longer than that of the logic gate shown in Fig. 2.

The delay time can be decreased by increasing the resistance of the resistor 75. However, when the output potential is changed from high level to low level, the charges of the base of the bipolar transistor 71 cannot be easily extracted. For this reason, a current flowing from the power source potential $V_{CC}$ to the ground potential $V_{SS}$ is increased, and the power consumption is increased.

As described above, in the conventional logic gate shown in Fig. 2, the high-level output potential is disadvantageously lower than the power source potential $V_{DD}$. In the conventional logic gate shown in Fig. 3 or 4, a gate delay time ($T_{PLH}$) wherein the output potential is changed from low level to high level is disadvantageously prolonged, or the power consumption is increased.

The present invention has been made to solve the above problem, and has as its object to provide a logic gate which can operate at a high speed with low power consumption and in which a high-level output potential is used as a power source potential $V_{DD}$ even when the logic gate is micropatterned to have a power source potential of about 3.3 V.

In order to achieve the above object, there is provided a logic gate comprising an input terminal, an output terminal, a first MOSFET of a first conductivity type having a source, a gate, and a drain, the source receiving a first potential, and the gate being connected to the input terminal, a second MOSFET of a second conductivity type having a source, a gate, and a drain, the source receiving a second potential, and the gate being connected to the input terminal, a third MOSFET of the second conductivity type having a source, a gate, and a drain, the second potential being applied to the source, the input terminal being connected to the gate, and the drain being connected to the output terminal, a bipolar transistor having a collector for receiving a third potential, a base connected to drains of the first and second MOSFETs, and an emitter connected to the output terminal, and a resistive element connected between the base and emitter of the bipolar transistor.

This invention can be more fully understood from the following detailed description when taken in conjunction with the accompanying drawings, in which:

Figs. 1 to 4 are circuit diagrams showing conventional logic gates;

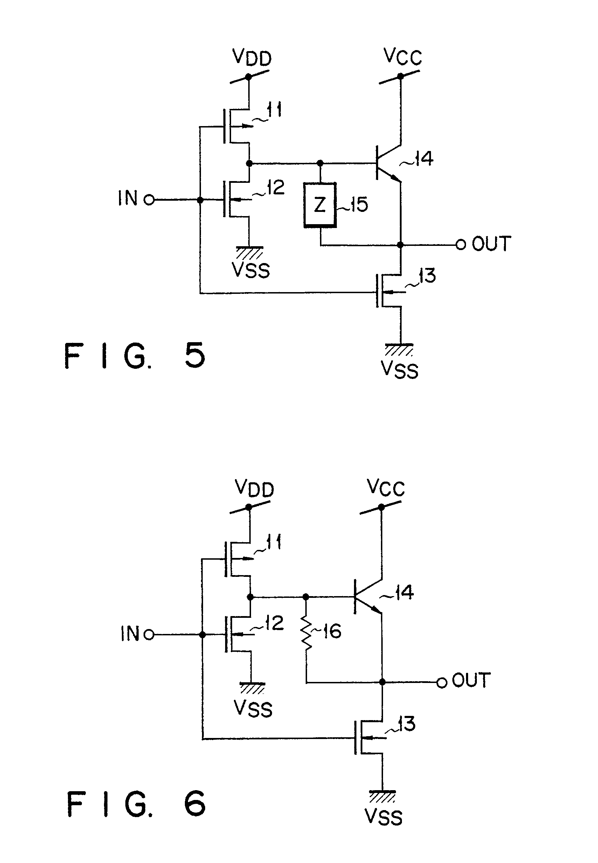

Fig. 5 is a circuit diagram showing a basic arrangement of a logic gate according to the first embodiment of the present invention;

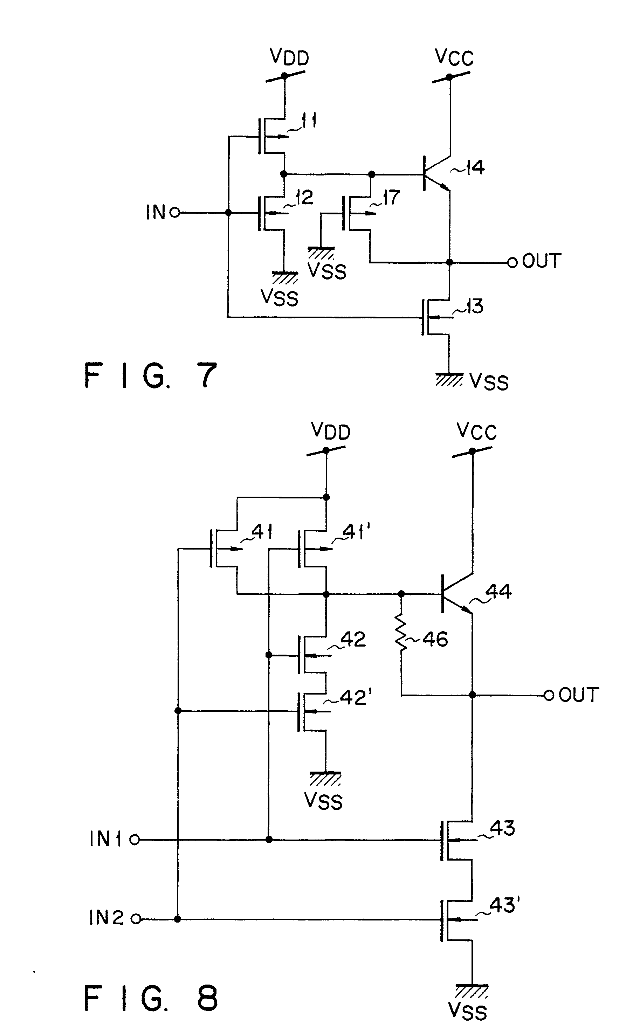

Figs. 6 and 7 are circuit diagrams showing the logic gate in Fig. 5;

Fig. 8 is a circuit diagram showing a basic arrangement of a logic gate according to the second embodiment of the present invention; and

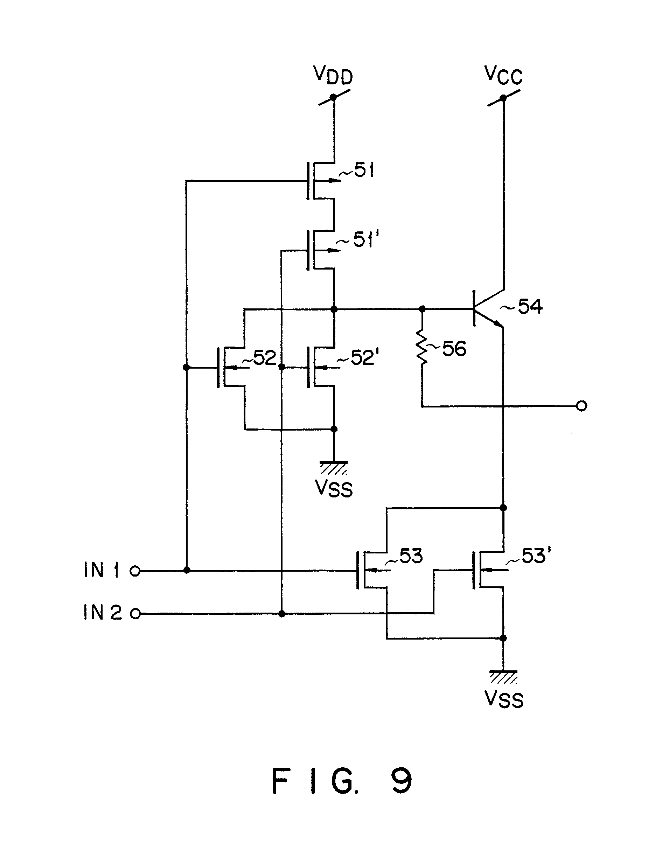

Fig. 9 is a circuit diagram showing a basic arrangement of a logic gate according to the third embodiment of the present invention.

An embodiment of the present invention will be described below with reference to the accompanying drawings.

Fig. 5 shows a basic arrangement of a logic gate according to the first embodiment of the present invention. The source of a p-channel MOSFET 11 is connected to a power source potential $V_{DD}$, and the gate of the MOSFET 11 is connected to an input terminal IN. The source of an n-channel MOSFET 12 is connected to a ground potential $V_{SS}$, and the gate of the MOSFET 12 is connected to the input terminal IN. The source of an n-channel MOSFET 13 is connected to the ground potential $V_{SS}$, the gate of the MOSFET 13 is connected to the input terminal IN, and the drain of the MOSFET 13 is connected to an output terminal OUT. The collector of an npn bipolar transistor 14 is connected to a power source potential $V_{CC}$, the base of the bipolar transistor 14 is connected to the drains of the MOSFETs 11 and 12, and the emitter of the bipolar transistor 14 is connected to the output terminal OUT. A resistive element 15 is connected between the base and emitter of the bipolar transistor 14. Although the power source potential $V_{CC}$ is generally equal to the power source potential $V_{DD}$, when an element is micropatterned, a relation of $V_{CC} \geq V_{DD}$ is satisfied to prevent the degradation of element characteristics.

In a logic gate with the above arrangement, the drain of the MOSFET 12 constituting an inverter is connected to the base of the bipolar transistor 14. For this reason, when the output potential is changed from high level to low level, charges can be immediately extracted from the base of the bipolar transistor 14. The resistive element 15 is connected between the base and emitter of the bipolar transistor 14. In order to use the high-level output potential as the power source potential $V_{DD}$, a resistor or a p-channel MOSFET can be used as the resistive element 15.

Fig. 6 shows an embodiment wherein a resistor 16 is used as the resistive element 15 of the logic gate shown in Fig. 5. An operation of the logic gate shown in Fig. 6 will be described below.

A case wherein a high-level potential "1" is applied to the input terminal IN will be described. In this case, the MOSFET 11 is set in an OFF state, and the MOSFETs 12 and 13 are set in an ON state. Therefore, the bipolar transistor 14 is set in an OFF state, and a low-level output potential "0" is output to the output terminal OUT.

A case wherein the potential of the input terminal is changed from "1" to "0" will be described. In this case, the MOSFET 11 is turned on, and the MOSFETs 12 and 13 are turned off. Therefore, currents are respectively supplied from the power source potential $V_{DD}$ to the base of the bipolar transistor 14 and the resistor 16. At this time, a potential difference is produced between the two terminals of the resistor 16. As a result, the bipolar transistor 14 is turned on, and a high-level output potential "1" is output to the output terminal OUT. Since the resistor 16 is connected between base and emitter of the bipolar transistor 14, the output potential "1" is the power source potential $V_{DD}$.

A case wherein the potential of the input terminal is changed from "0" to "1" will be described. In this case, the MOSFET 11 is turned off, and the MOSFETs 12 and 13 are turned on. Therefore, a low-level output potential "0" is output to the output terminal OUT. Since the charges of the base of the bipolar transistor 14 are extracted to the ground potential $V_{SS}$ through the MOSFET 12, the bipolar transistor 14 is rapidly turned off. Therefore, a through current generated when the MOSFET 13 and the bipolar transistor 14 are simultaneously turned on is suppressed.

The resistor 16 will be described below. As the resistor 16, a pinch resistor having a resistance of about 50 kΩ or a polysilicon resistor having a resistance of 1 GΩ to 1 TΩ and used in an E/R-SRAM (static random access memory constituted by an enhancement type transistor and a resistor) cell can be used. When a resistor having a large resistance is used, the high-level output potential "1" corresponds to the power source potential $V_{DD}$ in a steady state. However, when the logic gate is operated in a frequency of about 100 MHz, a time constant is very large. As a result, the high-level output potential "1" is lower than the power source potential $V_{DD}$ in a transition state. Note that, since the high-level output potential "1" corresponds to the power source potential $V_{DD}$ in the steady state, no through current is generated in other logic gates such as a CMOS gate, a Bi-CMOS gate, and Bi-NMOS gate to which the output potential is input.

Fig. 7 shows an embodiment wherein a p-channel MOSFET 17 having a gate connected to a ground potential $V_{SS}$ is used as the resistive element 15 of the logic gate shown in Fig. 5. Although the operation of the logic gate shown in Fig. 7 is almost equal to the operation of the logic gate shown in Fig. 6, the operation of Fig. 7 is more advantageous than that of Fig. 6 in the following points.

That is, an operation wherein the potential of the input terminal is changed from "1" to "0" will be described below. When the potential of the input terminal is set to be "1", the ground potential $V_{SS}$ is applied to the base of the bipolar transistor 14. When the potential of the input terminal goes to "0", the MOSFET 11 is turned on, and currents are supplied to the base of the bipolar transistor 14 and the source of the p-channel MOSFET 17. However, the MOSFET 17 is turned on when the voltage between the gate and source of the MOSFET 17 exceeds a threshold voltage. Therefore, since no current is supplied to the MOSFET 17 until the voltage exceeds the threshold voltage, the bipolar transistor 14 can be rapidly turned on. That is, when the potential of the input terminal is changed from "1" to "0", the output potential can be rapidly changed from "0" to "1".

Fig. 8 shows a 2-input NAND gate according to the second embodiment of the present invention. The sources of p-channel MOSFETs 41 and 41' are connected to a power source potential $V_{DD}$. The gate of the MOSFET 41' is connected to an input terminal IN1, and the gate of the MOSFET 41 is connected to an input terminal IN2. The gate of an n-channel MOSFET 42 is connected to the input terminal IN1. The drain of an n-channel MOSFET 42' is connected to the source of the MOSFET 42, and the gate of the MOSFET 42' is connected to the input terminal IN2. The gate of an n-channel MOSFET 43 is connected to the input terminal IN1, and the drain of the MOSFET 43 is connected to an output terminal OUT. The source of an n-channel MOSFET 43' is connected to a ground potential $V_{SS}$, the gate of the MOSFET 43' is connected to the input terminal IN2, and the drain of the MOSFET 43' is connected to the source of the MOSFET 43. The collector of an npn bipolar transistor 44 is connected to a power source potential $V_{CC}$, the base of the bipolar transistor 44 is connected to the drains of the MOSFETs 41, 41', and 42, and the emitter of the bipolar transistor 44 is connected to the output terminal OUT. A resistor 46 is connected between the base and emitter of the bipolar transistor 14. Although the power source potential $V_{CC}$ is generally equal to the power source potential $V_{DD}$, when an element is micropatterned, a relation of $V_{CC} \geqq V_{DD}$ is satisfied to prevent the degradation in element characteristics.

In the logic gate with the above arrangement, the base of the bipolar transistor 44 is connected to the ground potential $V_{SS}$ through the MOSFETs 42 and 42'. For this reason, when the output potential is changed from high level to low level, charges can be immediately extracted from the base of the bipolar transistor 44. The resistor 46 is connected between the base and emitter of the bipolar transistor 44. The resistor 46 uses a high-level output potential as the power source potential $V_{DD}$. Note that a p-channel MOSFET having a gate connected to the potential $V_{SS}$ can be used in place of the resistor.

An operation of the 2-input NAND gate shown in Fig. 8 will be described below.

A case wherein a high-level potential "1" is applied to the input terminals IN1 and IN2 will be described. In this case, the MOSFETs 41 and 41' are set in an OFF state, the MOSFETs 42 and 42' are set in an ON state, and the MOSFETs 43 and 43' are set in an ON state. Therefore, the bipolar transistor 44 is set in an OFF state, and a low-level output potential "0" is output to the output terminal OUT.

A case wherein the potentials of the input terminals IN1 and IN2 are changed from "1" to "0" will be described. In this case, the MOSFETs 41 and 41' are turned on, the MOSFETs 42 and 42' are turned off, and the MOSFETs 43 and 43' are turned off. Therefore, currents are supplied from the power source potential $V_{DD}$ to the base of the bipolar transistor 44 and the resistor 46. At this time, a potential difference is produced between the two terminals of the resistor 46. As a result, the bipolar transistor 44 is turned on, and a high-level output potential "1" is output to the output terminal OUT. Note that, since the resistor is connected between the base and emitter of the bipolar transistor 44, the output potential "1" is the power source potential $V_{DD}$.

A case wherein the potential of the input terminal is changed from "0" to "1" will be described. In this case, the MOSFETs 41 and 41' are turned off, the MOSFETs 42 and 42' are turned on, and the MOSFETs 43 and 43' are turned on. Therefore, a low-level output potential "0" is output to the output terminal OUT. Since the charges of the base of the bipolar transistor 44 are extracted to the ground potential $V_{SS}$ through the MOSFETs 42 and 42' and the resistor 46, the bipolar transistor 44 is rapidly turned off. Thus, a current generated when the MOSFETs 43 and 43' and the bipolar transistor 44 are simultaneously turned on is suppressed.

As described above, in the embodiment shown in Fig. 8, the same effect as that of the embodiments shown in Figs. 5 to 7 can be obtained.

Fig. 9 shows a 2-input NOR gate according to the third embodiment of the present invention. The gate of a p-channel MOSFET 51 is connected to an input terminal IN1, and the source of the MOSFET 51 is connected to a power source potential $V_{DD}$. The source of the p-channel MOSFET 51' is connected to the drain of the MOSFET 51, and the gate of the MOSFET 51' is connected to an input terminal IN2. The sources of the n-channel MOSFETs 52 and 52' are connected to a ground potential $V_{SS}$. The gate of the MOSFET 52 is connected to the input terminal IN1, and the gate of the MOSFET 52' is connected to the input terminal IN2. The gate of an n-channel MOSFET 53 is connected to the input terminal IN1, the source of the MOSFET 53 is connected to the ground potential $V_{SS}$, and the drain of the MOSFET 53 is connected to an output terminal OUT. The gate of an n-channel MOSFET 53' is connected to the input terminal IN2, the source of the MOSFET 53' is connected to the ground potential $V_{SS}$, and the drain of the MOSFET 53' is connected to the output terminal OUT. The collector of an npn bipolar transistor 54 is connected to a power source potential $V_{CC}$, the base of the bipolar transistor 54 is connected to the drains of the MOSFETs 51', 52, and 52', and the emitter of the bipolar transistor 54 is connected to the output terminal OUT. A resistor 56 is connected between the base and the emitter of the bipolar transistor 54. Although the power source potential $V_{CC}$ is generally equal to a power source potential $V_{DD}$, when an element is micropatterned, a relation of $V_{CC} \geq V_{DD}$ is satisfied to prevent the degradation of element characteristics.

In the logic gate with the above arrangement, the base of the bipolar transistor 54 is connected to the ground potential $V_{SS}$ through the MOSFETs 52 and 52'. For this reason, when the output potential is changed from high level to low level, charges can be immediately extracted from the base of the bipolar transistor 54. The resistor 56 is connected between the base and emitter of the bipolar transistor 54. The resistor 56 uses a high-output potential as the power source potential $V_{DD}$. Note that a p-channel MOSFET having a gate connected to the ground potential $V_{SS}$ can be used in place of the resistor.

As described above, in the embodiment shown in Fig. 9, the same effect as that of the embodiments shown in Figs. 5 to 7 can be obtained.

Reference signs in the claims are intended for better understanding and shall not limit the scope.

## Claims

1.  A logic gate comprising:
    an input terminal (IN);
    an output terminal (OUT);
    a first MOSFET (11) of a first conductivity type having a source, a gate, and a drain, the source receiving a first potential ($V_{DD}$), and the gate being connected to said input terminal;
    a second MOSFET (12) of a second conductivity type having a source, a gate, and a drain, the source receiving a second potential ($V_{SS}$), and the gate being connected to said input terminal;
    a third MOSFET (13) of the second conductivity type having a source, a gate, and a drain, the second potential being applied to the source, said input terminal being connected to the gate, and the drain being connected to said output terminal;
    a bipolar transistor (14) having a collector for receiving a third potential ($V_{CC}$), a base connected to drains of said first and second MOSFETs, and an emitter connected to said output terminal; and
    a resistive element (15) connected between the base and emitter of said bipolar transistor.

2.  A logic gate according to claim 1, characterized in that said resistive element is a pinch resistor (16).

3.  A logic gate according to claim 1, characterized in that said resistive element is a MOSFET of the first conductivity type having a gate for receiving the second potential, a source connected to the base of said bipolar transistor, and a drain connected to the emitter of said bipolar transistor.

4.  A logic gate according to claim 1, characterized in that said first MOSFET is a p-channel MOSFET, said second and third MOSFETs are n-channel MOSFETs, and said bipolar transistor is an npn bipolar transistor.

5.  A logic gate according to claim 1, characterized in that said first MOSFET has a source for receiving a first power source potential, said second and third MOSFETs have sources for receiving a ground potential, and said bipolar transistor has a collector for receiving a second power source potential.

6. A logic gate according to claim 5, characterized in that the first power source potential is equal to the second power source potential.

7. A logic gate according to claim 5, characterized in that the first power source potential is lower than the power source potential.

8. A logic gate according to claim 1, characterized in that said logic gate constitutes an inverter.

9. A logic gate according to claim 1, characterized in that said logic gate has a plurality of input terminals and constitutes a NAND gate.

10. A logic gate according to claim 1, characterized in that said logic gate has a plurality of input terminals and constitutes a NOR gate.

F I G. 1

F I G. 2

F I G. 3

F I G. 4

8

FIG. 5

FIG. 6

FIG. 7

FIG. 8

F I G. 9